# EUROPEAN PATENT APPLICATION

(11) **EP 4 546 419 A1**
(43) Date of publication of application: **30.04.2025**
(21) Application number: 24206390.7
(22) Date of filing: 14.10.2024
(51) Int. Cl.: H01L 23/528, H10D 84/01, H10D 88/00, H10D 89/10

(54) **INTEGRATED CIRCUIT DEVICES HAVING DUAL POWER SOURCES**

(30) Priority: 23.10.2023 US 202363592269 P; 13.03.2024 US 202418603656
(71) Applicant: Samsung Electronics Co., Ltd, Suwon-si, Gyeonggi-do 16677 (KR)
(72) Inventor: KIM, Jintae, San Jose, CA, 95134 (US); PARK, Panjae, San Jose, CA, 95134 (US); SEO, Kang-Ill, San Jose, CA, 95134 (US)
(74) Representative: Kuhnen & Wacker Patent- und Rechtsanwaltsbüro PartG mbB

(57) **Abstract**

CMOS devices are provided. A CMOS device includes a PMOS transistor (T-P) and an NMOS transistor (T-N). Moreover, the CMOS device includes a dual power rail having a front-side power rail (FSR) and a back-side power rail (BSR) that are both coupled to one of the PMOS transistor (T-P) or the NMOS transistor (T-N). The PMOS transistor (T-P) and the NMOS transistor (T-N) are in a vertical transistor stack, or are side-by-side.

## Description

### TECHNICAL FIELD

The present disclosure generally relates to the field of integrated circuit devices and, more particularly, to integrated circuit devices having dual power sources.

### BACKGROUND OF THE INVENTION

Integrated circuit (IC) devices, chips, and/or blocks may receive power and data signals from one or more external sources (e.g., a power source and a data source) as part of an operation. Some IC devices may receive power and data signals via front-side (FS) conductive structures. For example, an IC device may include a FS power distribution network (FSPDN) having one or more components that are formed during back end of line (BEOL) processes, and conductive structures for data signals may be on the same side of an IC device as the FSPDN. IC devices may include various transistor structures, including, for example, two-dimensional (2D) planar structures, fin field-effect transistors (FinFETs), gate-all-around transistors, multi-bridge channel FETs (MBCFETs^{™}), and stacked transistors (e.g., three-dimensional (3D) stacked transistors).

More recently, back-side PDNs (BSPDNs), in which a backside of a substrate of an IC device is used as a power distribution network (PDN), have also been developed. For example, a power rail may be used in a BSPDN of an IC device, and may be on a side of the substrate opposite from active components (e.g., transistors) of the IC device. Moreover, conductive structures for data signals may be on an FS of the IC device, and thus the BSPDN and the conductive structures for the data signals may be on opposite sides of the IC device.

Regardless of whether FS power or BS power is provided, the use of a single power source may make it difficult to control power consumption. Conventional blocks of IC devices may be designed as separate high-voltage blocks and low-voltage blocks, with each block receiving a single voltage (a high voltage or a low voltage). Accordingly, conventional blocks may need to be designed and/or separated based on voltage level.

### SUMMARY OF THE INVENTION

Embodiments of the invention are set out in the appended claims.

An integrated circuit device, according to some embodiments herein, may include a vertical transistor stack that includes a first transistor having a first conductivity type and a second transistor having a second conductivity type that is different from the first conductivity type. For example, the device may be a complementary metal-oxide-semiconductor (CMOS) device, the first transistor may be a p-type metal-oxide-semiconductor (PMOS) transistor and the second transistor may be an n-type metal-oxide-semiconductor (NMOS) transistor. Moreover, the CMOS device may include first and second power sources respectively coupled to a front-side (FS) power rail and a back-side (BS) power rail, with both the front-side and back-side power rails coupled to the PMOS transistor.

An integrated circuit device, according to some embodiments herein, may include a substrate having a PMOS transistor and an NMOS transistor. The integrated circuit device may include a front-side (FS) power rail and a back-side (BS) power rail that are both coupled to the PMOS transistor. The integrated circuit device may include an FS power source and a BS power source that are coupled to the PMOS transistor via the FS power rail and the BS power rail, respectively. Moreover, the CMOS device may include a controller that is coupled to the FS power source and the BS power source. The controller may be configured to activate the FS power source while the BS power source is deactivated, and may be further configured to activate the BS power source while the FS power source is deactivated.

An integrated circuit device, according to some embodiments herein, may include a vertical transistor stack that includes a first transistor and a second transistor. The integrated circuit device may include a first power source configured to supply a first power signal having a first voltage and a second power source configured to supply a second power signal having a second voltage that is higher than the first voltage. The first power source and the second power source may be both coupled to the first transistor. Moreover, the CMOS device may include a controller that is coupled to the first power source and the second power source. The controller may be configured to turn on the first power source while the second power source is turned off, and may be further configured to turn on the second power source while the first power source is turned off.

### BRIEF DESCRIPTION OF THE DRAWINGS

FIG. 1 is a schematic block diagram of a device according to some embodiments herein.
FIGs. 2 and 3 are example cross-sectional views of a standard cell of the device of FIG. 1.
FIGs. 4A and 4B are cross-sectional views illustrating operations of turning on/off power sources coupled to the standard cell of FIG. 2.

### DETAILED DESCRIPTION

Pursuant to embodiments herein, IC devices are provided that each include a dual power source that may provide power at both a FS and a BS of the IC device. The dual power source may include a first power source coupled to the IC device via a first power rail (e.g., via a FS power rail) and a second power source coupled to the IC device via a second power rail (e.g., via a BS power rail). A power signal provided at the FS may be different from a power signal provided at the BS. For example, the FS can use a relatively narrow power rail to provide a relatively low voltage, and the BS can use a relatively wide power rail to provide a relatively high voltage. This may avoid a need to design and/or separate blocks based on voltage level. The first and second power rails configured to provide respective first and second power signals to a same first transistor may be referred to herein as dual power rails.

In other words, both the first and second power rails (FS and BS) of a dual power rail may be connected to the same transistor (e.g., a p-channel MOS (PMOS) transistor) at the same time, though the first and second power rails may not be active at the same time. For example, the FS power rail may be active (i.e., coupled to a power source that is on) while the BS power rail is inactive (i.e., coupled to a power source that is off), or vice versa. In some embodiments, a designer of an IC device may control which power rail to turn on based on the purpose or operation of the IC device or block thereof. In some embodiments, a controller may select between power sources (and corresponding power rails) based on functional needs and/or power consumption settings. A dual power rail may thus advantageously optimize power consumption based on block purpose (e.g., low-power or high-power).

Some examples of embodiments of the present disclosure will be described in greater detail with reference to the attached figures.

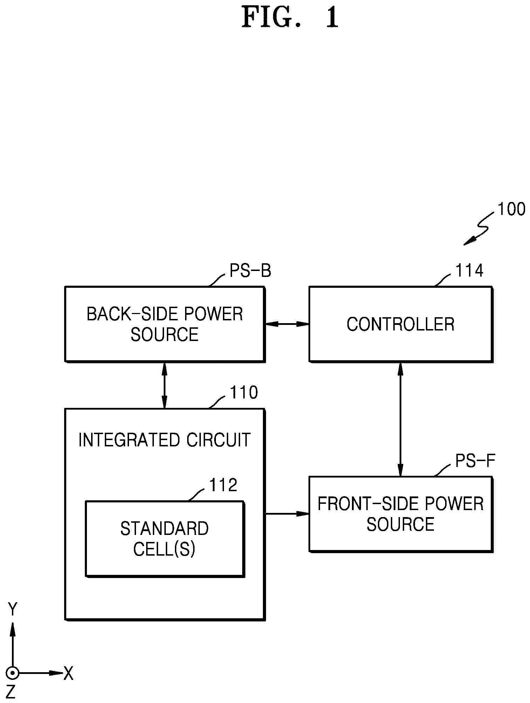

FIG. 1 is a schematic block diagram of a device 100 according to some embodiments herein. The device 100 may be referred to as a CMOS device. The device 100 includes an IC 110, which has one or more standard cells 112 (e.g., one or more blocks). For example, a standard cell 112 may be a CMOS standard cell comprising a PMOS transistor and an n-channel MOS (NMOS) transistor.

The device 100 also includes a first power source PS-F (e.g., a FS power source) and a second power source PS-B (e.g., a BS power source) that are each coupled to the IC 110. In some embodiments, the first power source PS-F and the second power source PS-B may provide different power signals having different voltage levels to the IC 110. As an example, the first power source PS-F may be configured to provide a first voltage (e.g., 0.4-0.7 volts), and the second power source PS-B may be configured to provide a second voltage (e.g., 0.7-1.1 volts) that is relatively higher than the first voltage.

According to some embodiments, the second voltage may be at least 0.7 volts, and the first voltage may be a non-zero voltage that is below 0.7 volts (e.g., below the second voltage). In some embodiments, the second voltage may be above 0.7 volts, and the first voltage may be a non-zero voltage that does not exceed 0.7 volts (e.g., that does not exceed the second voltage).

Though various examples herein describe a lower-voltage power source (e.g., the first power source PS-F) and a higher-voltage power source (e.g., the second power source PS-B), the first power source PS-F and the second power source PS-B may instead be a higher-voltage and a lower-voltage power source, respectively, in other examples. Lower-power wiring (e.g., a lower-power power rail) is typically on the FS, and higher-power wiring (e.g., a higher-power power rail) is typically on the BS, because the BS typically has more space for higher-power (e.g., wider) wiring. However, the present disclosure is not limited thereto.

For simplicity of illustration, the first power source PS-F and the second power source PS-B are both shown in the X-Y plane in FIG. 1. It will be understood, however, that the first power source PS-F and the second power source PS-B may be at different levels in the Z-direction, with the IC 110 coupled therebetween. Similarly, though the first power source PS-F and the second power source PS-B are shown at different positions along the X-direction in FIG. 1, it will be understood that the first power source PS-F and the second power source PS-B may be in parallel with each other along the X-direction. It will also be understood that the first power source PS-F and the second power source PS-B may be spaced relatively apart from the IC 110.

The device 100 further includes a controller 114 that is coupled to both the first power source PS-F and the second power source PS-B. The controller 114 may include one or more microprocessors (not shown) that are configured to control operations of the first power source PS-F and the second power source PS-B. For example, the controller 114 may include a microprocessor that is configured to turn the first power source PS-F on or off. The same microprocessor, or a different microprocessor in the controller 114, may be configured to turn the second power source PS-B on or off. As shown in FIG. 1, the controller 114 may be external to (i.e., outside of) the IC 110 that includes the standard cell(s) 112.

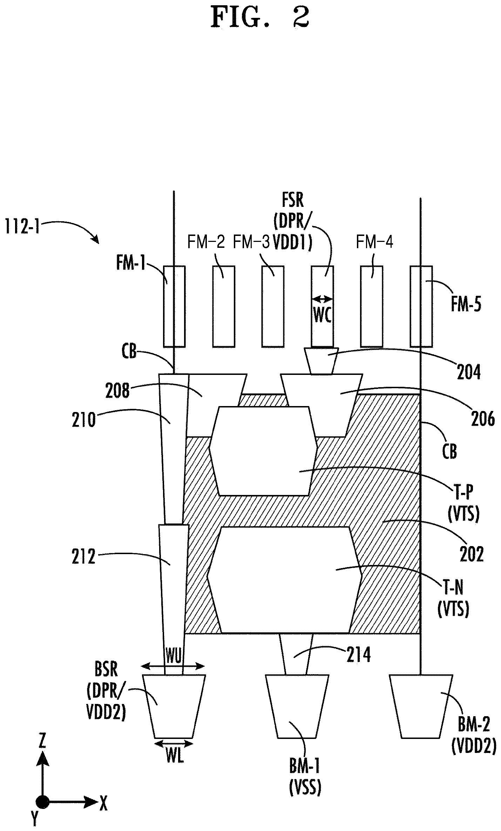

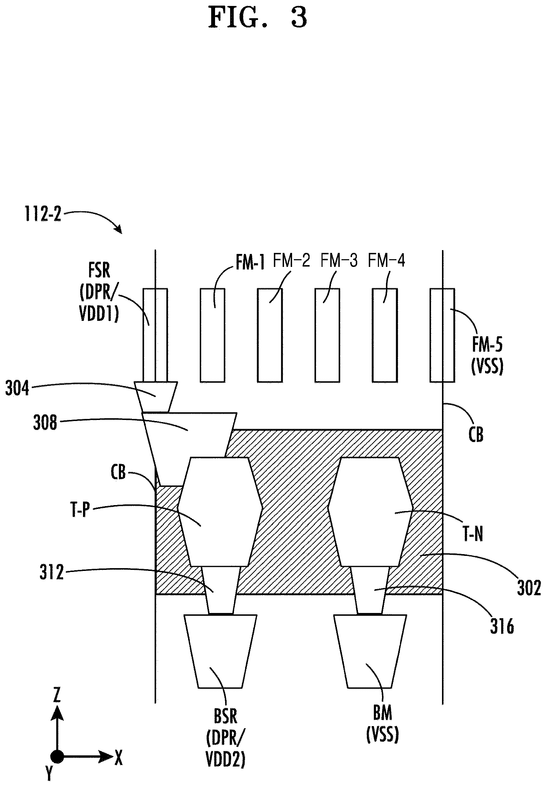

FIGs. 2 and 3 are example cross-sectional views of a standard cell 112 of FIG. 1.

FIG. 2 shows a standard cell 112-1 having a PMOS transistor T-P and an NMO S transistor T-N that are in a vertical transistor stack VTS in (and/or on) a substrate 202. For example, the PMOS transistor T-P may be on top of (i.e., may overlap vertically) the NMOS transistor T-N. Accordingly, an axis that extends in a vertical (Z) direction passes through both the PMOS transistor T-P and the NMOS transistor T-N.

FIG. 3, on the other hand, shows a standard cell 112-2 in which the PMOS transistor T-P and the NMOS transistor T-N are side-by-side in (and/or on) a substrate 302. The PMOS transistor T-P may horizontally overlap the NMOS transistor T-N. An axis that extends in a lateral (X) direction thus passes through both the PMOS transistor T-P and the NMOS transistor T-N. In some embodiments, the side-by-side transistors (e.g., the PMOS transistor T-P and the NMOS transistor T-N) may be FinFETs. In other embodiments, the side-by-side transistors may be planar transistors.

The cross-sectional views in FIGs. 2 and 3 each show a portion of the PMOS transistor T-P and a portion of the NMOS transistor T-N. The portion of the PMOS transistor T-P that is shown in FIG. 2 may be a source/drain (S/D) region of the PMOS transistor T-P. Also, the portion of the NMOS transistor T-N that is shown in FIG. 2 may be an S/D region of the NMOS transistor T-N. Likewise, the portion of the PMOS transistor T-P that is shown in FIG. 3 may be an S/D region of the PMOS transistor T-P, and the portion of the NMOS transistor T-N that is shown in FIG. 3 may be an S/D region of the NMOS transistor T-N. Moreover, the PMOS transistor T-P and the NMOS transistor T-N may, in some embodiments, be respective FETs (e.g., vertically-stacked FETs or side-by-side FETs).

As shown in FIG. 2, the substrate 202 (e.g., a semiconductor substrate) of the standard cell 112-1 may be coupled between two power rails of a dual power rail DPR, including a first power rail FSR and a second power rail BSR. Accordingly, the first and second power rails FSR and BSR are on/adjacent to opposite (front and back) sides of the substrate 202. For example, the first power rail FSR is on (or adjacent to) a front side of the substrate 202, the second power rail BSR is on (or adjacent to) a back side of the substrate 202.

The first power rail FSR may be narrower, in the X-direction, than the second power rail BSR. As an example, a width WU of an uppermost surface of the second power rail BSR may be at least double (or even at least triple) a width WC of the first power rail FSR. In some embodiments, the width WU of the second power rail BSR may be wider than a width WL of a lowermost surface of the second power rail BSR, whereas the width WC of the first power rail FSR may be constant (i.e., the same for the uppermost and lowermost surfaces of the first power rail FSR). The lowermost width WL of the second power rail BSR may be wider than (e.g., at least 50% wider, or even at least double) the constant width WC, of the first power rail FSR and the uppermost width WU of the second power rail BSR may be at least twice as wide as the constant width WC of the first power rail BSR.

The first and second power rails FSR and BSR may have different shapes in the X-Z plane. For example, the first power rail FSR may be rectangular, whereas the second power rail BSR may be a non-rectangular quadrilateral, such as a trapezoid. In some embodiments in which the PMOS transistor T-P is on top of the NMOS transistor T-N, the PMOS transistor T-P may be closer to the first power rail FSR than to the second power rail BSR.

In some embodiments, the PMOS transistor T-P and the NMOS transistor T-N may be of different sizes. For example, an S/D region of the PMOS transistor T-P may have a smaller surface area in the X-Z plane than an S/D region of the NMOS transistor T-N that is overlapped (in the Z-direction) by the S/D region of the PMOS transistor T-P. As an example, the S/D region of the PMOS transistor T-P may be narrower (in the X-direction) than the S/D region of the NMOS transistor T-N.

The first and second power rails FSR and BSR may both be coupled to the PMOS transistor T-P. The first and second power rails FSR and BSR may be metal lines/wiring that may be configured to transmit a lower-voltage power and a higher-voltage power, respectively, to the PMOS transistor T-P. The lower-voltage power may be a lower drain-supply voltage VDD1 (e.g., 0.4-0.7 volts), and the higher-voltage power may be a higher drain-supply voltage VDD2 (e.g., 0.7-1.1 volts).

In addition to the first power rail FSR, the FS of the standard cell 112-1 includes metal lines (e.g., interconnections) FM-1, FM-2, FM-3, FM-4, and FM-5, which may be at the same level (in the Z-direction) as the first power rail FSR. One or more of the metal lines FM (e.g., FM-1 through FM-4) may be a signal-line that may be configured to transmit data rather than power. In some embodiments, another of the metal lines FM (e.g., FM-5) may be configured to transmit power, such as a source-supply (e.g., negative power supply) voltage VSS. For example, the source-supply voltage VSS may be zero volts (0V). The metal line FM-5, however, is not limited to transmitting power. Accordingly, the metal line FM-5 may be a signal-line that is configured to transmit data rather than power.

The first power rail FSR may be coupled to the PMOS transistor T-P by a FS via 204 and an S/D contact 206. The S/D contact 206 may contact a first S/D region of the PMOS transistor T-P. Another S/D contact 208 may also contact the first S/D region of the PMOS transistor T-P. The S/D contact 208 may be at the same level (in the Z-direction) as the S/D contact 206, and may be spaced apart (e.g., separated) from the S/D contact 206 in the X-direction. A second S/D region of the PMOS transistor T-P is not shown in FIG. 2, but rather may be in parallel with the first S/D region of the PMOS transistor T-P in (or on) the substrate 202 at a depth in the Y-direction different from the depth that is shown in FIG. 2. The second power rail BSR may be coupled to the S/D contact 208 by a first via 210 and a second via 212 that are in the substrate 202.

In addition to the second power rail BSR, the BS of the standard cell 112-1 includes metal lines BM-1 and BM-2 that may be power rails. For example, the metal line BM-1 may be configured to transmit a source-supply voltage VSS to the NMOS transistor T-N. The metal line BM-2 may be configured to transmit the higher drain-supply voltage VDD2. Moreover, the metal lines BM-1 and BM-2 may be at the same level (in the Z-direction) as the second power rail BSR, and may overlap each other in a horizontal direction (e.g., the X-direction).

The metal line BM-1 may be coupled to the NMOS transistor T-N by a BS via 214. The metal line BM-2 may be coupled to the substrate 202 (e.g., to an element thereon) by one or more vias not shown in FIG. 2. For example, the via(s) may be in the substrate 202 at a depth in the Y-direction different from the depth that is shown in FIG. 2.

As shown in FIG. 2, the standard cell 112-1 has two parallel cell boundaries CB. In some embodiments, the metal line FM-1, the first and second vias 210 and 212, and the second power rail BSR may each be on a first of the cell boundaries CB. Moreover, the metal lines FM-5 and BM-2 may each be on a second of the cell boundaries CB.

As shown in FIG. 3, the substrate 302 (e.g., a semiconductor substrate) of the standard cell 112-2 may be coupled between two power rails (a first power rail FSR and a second power rail BSR) of a dual power rail DPR. The two power rails FSR and BSR may both be coupled to PMOS transistor T-P. The first power rail FSR may be configured to transmit a lower drain-supply voltage VDD1 (e.g., 0.4-0.7 volts) to the PMOS transistor T-P, and the second power rail BSR may be configured to transmit a higher drain-supply voltage VDD2 (e.g., 0.7-1.1 volts) to the PMOS transistor T-P.

The first power rail FSR may be coupled to the PMOS transistor T-P by an FS via 304 and a contact 308. For example, the contact 308 may be an S/D contact that contacts a top portion of an S/D of the PMOS transistor T-P. Also, the second power rail BSR may be coupled to the PMOS transistor T-P by a via 312. In some embodiments, the via 312 may contact a bottom portion of the S/D of the PMOS-transistor T-P.

In addition to the second power rail BSR, the BS of the standard cell 112-2 includes a BS metal line BM that may be a power rail. For example, the metal line BM may be configured to transmit a source-supply voltage VSS to an NMOS transistor T-N. The BS metal line BM may be coupled to the NMOS transistor T-N by a via 316. For example, the via 316 may contact a bottom portion of the NMOS-transistor T-N. In some embodiments, the vias 312 and 316 may be at the same level (in the Z-direction) as each other. Moreover, the PMOS transistor T-P and the NMOS transistor T-N may be at the same level (in the Z-direction) as each other. As an example, the PMOS transistor T-P and the NMOS transistor T-N may have respective uppermost surfaces that are coplanar and respective lowermost surfaces that are coplanar. According to some embodiments, the PMOS transistor T-P and the NMOS transistor T-N may have the same cross-sectional shape and/or surface area in the X-Z plane.

In addition to the first power rail FSR, the FS of the standard cell 112-2 includes metal lines (e.g., interconnections) FM-1 through FM-5. One or more of the metal lines FM (e.g., FM-1 through FM-4) may be a signal-line that is configured to transmit data rather than power. In some embodiments, another of the metal lines FM (e.g., FM-5) may be configured to transmit power, such as a source-supply voltage VSS.

As shown in FIG. 3, the standard cell 112-2 has two parallel cell boundaries CB. In some embodiments, the first power rail FSR, the FS via 304, and the contact 308 may each be on a first of the cell boundaries CB. Moreover, a metal line FM-5 may be on a second of the cell boundaries CB.

The metal lines FM-1 through FM-5 may each be coupled to the substrate 302 (e.g., to a respective element thereon) by one or more vias not shown in FIG. 3. For example, the via(s) may be in the substrate 302 at a depth in the Y-direction different from the depth that is shown in FIG. 3.

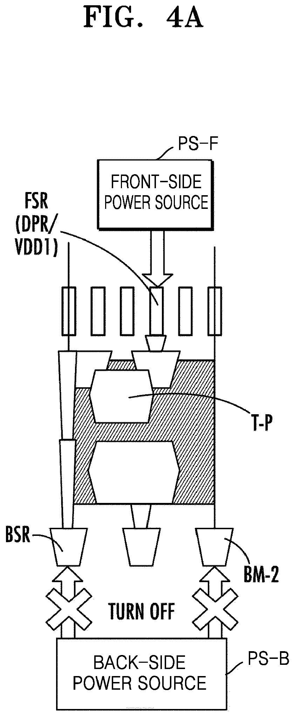

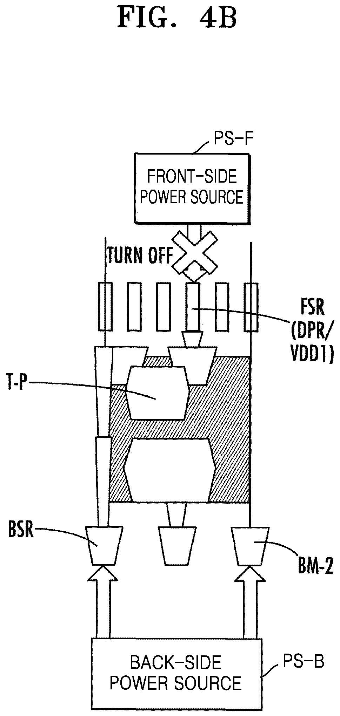

FIGs. 4A and 4B are cross-sectional views illustrating operations of turning on/off power sources PS coupled to the standard cell 112-1 of FIG. 2.

As shown in FIG. 4A, the first power source PS-F is turned on (i.e., is active), and thus is providing power to the PMOS transistor T-P. The second power source PS-B is turned off (i.e., is inactive), and thus is not providing power to the PMOS transistor T-P. Accordingly, lower power (a lower voltage) may be provided to the PMOS transistor T-P by the first power rail FSR, and no power may be provided to the standard cell 112-1 via the second power rail BSR. Also, no power may be provided to the standard cell 112-1 via the metal line BM-2.

As shown in FIG. 4B, the second power source PS-B is turned on (i.e., is active), and thus is providing power to the PMOS transistor T-P. The first power source PS-F is turned off (i.e., is inactive), and thus is not providing power to the PMOS transistor T-P. Higher power (a higher voltage) is thus being provided to the PMOS transistor T-P by the second power rail BSR, and no power may be provided to the standard cell 112-1 via the first power rail FSR. Also, higher power may be provided to the standard cell 112-1 via the metal line BM-2.

Accordingly, though the first power source PS-F and the second power source PS-B are both coupled to the PMOS transistor T-P at the same time, only one of the first power source PS-F or the second power source PS-B is supplying power to the PMOS transistor T-P at a given time. The controller 114 (FIG. 1) may activate one of the first power source PS-F or the second power source PS-B while the other of the first power source PS-F or the second power source PS-B is inactive.

The device 100 (FIG. 1) according to some embodiments herein may provide a number of advantages. These advantages may include improved control over power consumption by an IC 110 (FIG. 1) of the device 100. This improved control may be provided by having a dual power rail DPR (FIGS. 2 and 3) coupled to two separate power sources, including the first (FS) power source PS-F and the second (BS) power source PS-B (FIG. 1). The separate power sources may be configured to supply different power levels, and thus can be turned on or off based on power (voltage/performance) goals. As an example, when the IC 110 operates in a relatively higher-performance mode, it may use a higher-voltage power source (e.g., the second power source PS-B). For other operations, such as standard or lower-performance operations (or lower-power consumption operations), the IC 110 may use a lower-voltage power source (e.g., the first power source PS-F).

Only one of the two power sources PS for a standard cell 112 may be enabled at any given time. In contrast, conventional power-distribution techniques may lack a dual power rail DPR and/or separate first and second power sources PS-F and PS-B, the first power source PS-F configured to provide power signals having different power levels to the same standard cell 112. For example, conventional techniques may use a single power source (e.g., may have a power source only at the BS or only at the FS) for a standard cell (or block), which may make it difficult to provide detailed control of voltage and power consumption.

First and second power rails (power rails BSR and FSR) of the dual power rail DPR may be coupled to the same transistor (e.g., a PMOS transistor T-P) of a CMOS standard cell 112 (FIG. 1) of the IC 110. The dual power rail DPR can thus supply power signals (e.g., first and second power signals) having two different voltage levels (higher and lower) to the standard cell 112 (with only one of the voltage levels being supplied at a given time), thus eliminating or alleviating a need for voltage-level-specific standard cells (e.g., a higher-voltage-only standard cell and a separate, lower-voltage-only standard cell). Moreover, in some embodiments, the IC 110 may include the PMOS transistor T-P and an NMOS transistor T-N in a vertical transistor stack VTS (FIG. 2). In contrast, conventional power-distribution techniques may lack a CMOS vertical transistor stack that is coupled to a dual power rail (and/or coupled to separate power sources).

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present invention.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

## Claims

1. A complementary metal-oxide-semiconductor, CMOS, device comprising:
a first transistor (T-P) having a first conductivity type and a second transistor (T-N) having a second conductivity type that is opposite from the first conductivity type; and
a dual power rail comprising a first power rail (FSR) and a second power rail (BSR) that are on opposite sides of the first transistor (T-P) in the vertical direction (Z) and configured to provide respective power signals to the first transistor (T-P).

2. The CMOS device of Claim 1,
wherein the first transistor is closer to the first power rail than to the second power rail.

3. The CMOS device of Claim 1 or 2, wherein the first transistor and the second transistor are arranged to overlap each other in the vertical direction (Z) to form a vertical transistor stack.

4. The CMOS device of Claim 1 or 2, wherein the first transistor and the second transistor are arranged to overlap each other in a horizontal direction (X).

5. The CMOS device of any one of Claims 1 to 4, wherein the first transistor (T-P) is a PMOS transistor and the second transistor (T-N) is a NMOS transistor.

6. The CMOS device of any one of Claims 1 to 5,
wherein the first power rail (FSR) has a first width (WC), and
wherein the second power rail (BSR) has a second width (WU) that is wider than the first width, exemplarily an uppermost surface of the second power rail (BSR) is at least twice as wide as an uppermost surface of the first power rail (FSR).

7. The CMOS device of any one of Claims 1 to 6, further comprising a signal line (FM-1 to FM-5),
wherein the signal line (FM-1 to FM-5) is configured to transmit a data signal and on a side of the first transistor (T-P) in common with the first power rail (FSR).

8. The CMOS device of any one of Claims 1 to 7,
wherein the first power rail (FSR) is configured to transmit a first power signal having a first voltage (VDD1), and
wherein the second power rail (BSR) is configured to transmit a second power signal having a second voltage higher (VDD2) than the first voltage (VDD1).

9. The CMOS device of any one of Claims 1 to 8, further comprising a first frontside metal line (FM-3) and a second frontside metal line (FM-4),
wherein the first power rail (FSR) is an inner rail that is arranged in a horizontal direction between the first frontside metal line (FM-3) and the second frontside metal line (FM-4).

10. The CMOS device of any one of Claims 1 to 9, further comprising a first power source (PS-F) and a second power source (PS-B) that are coupled to the first transistor (T-P) via the first power rail (FSR) and the second power rail (BSR), respectively.

11. The CMOS device of Claim 10,
wherein the first power source (PS-F) is configured to provide a first power signal having a first voltage (VDD1) to the first transistor (T-P) through the first power rail (FSR), and
wherein the second power source (PS-B) is configured to provide a second power signal having a second voltage (VDD2) that is higher than the first voltage (VDD1) to the first transistor (T-P) through the second power rail (BSR).

12. The CMOS device of Claim 10 or 11, wherein the first power source (PS-F) is configured to be active while the second power source (PS-B) is inactive, and
wherein the second power source (PS-B) is configured to be active while the first power source (PS-F) is inactive.

13. The CMOS device of any one of Claims 10 to 12, further comprising a controller (114) that is coupled to both the first power source (PS-F) and the second power source (PS-B),
wherein the controller (114) is configured to:
activate the first power source (PS-F) while the second power source (PS-B) is inactive, and
activate the second power source (PS-B) while the first power source (PS-F) is inactive.

14. The CMOS device of any one of Claims 10 to 13,
wherein the second power rail (BSR) is a first backside power rail, and
wherein the CMOS device further comprises a second backside power rail (BM) that is coupled to the second power source (PS-B), wherein the second backside power rail (BM) may be arranged to overlap the first backside power rail in a horizontal direction.

15. The CMOS device of any one of Claims 1 to 14,
wherein the first transistor (T-P) comprises a first source/drain, S/D, region and a second S/D region, and
wherein the first power rail (FSR) and the second power rail (BSR) are both coupled to the first S/D region of the first transistor (T-P).
